# EUROPEAN PATENT SPECIFICATION

(11) **EP 2 951 957 B1**
(45) Date of publication and mention of the grant of the patent: **14.03.2018**
(21) Application number: 13874175.6
(22) Date of filing: 31.01.2013
(51) Int. Cl.: H04L 12/26, G06F 17/50, H04L 12/24

(54) **NETWORK SWITCH SIMULATION**
NETZVERMITTLUNGSSIMULATION
SIMULATION DE COMMUTATEUR DE RÉSEAU

(43) Date of publication of application: 09.12.2015
(73) Proprietor: Hewlett Packard Enterprise Development LP, Houston, TX 77070 (US)
(72) Inventor: MAURYA, Alok, Bangalore 5560048 Karnataka (IN)
(74) Representative: ZBM Patents - Zea, Barlocci & Markvardsen
(86) International application number: PCT/US2013/024176
(87) International publication number: WO 2014/120214

(56) References cited:
- US-A1- 2005 220 029
- US-A1- 2008 089 320
- US-A1- 2012 027 021
- US-A1- 2012 029 898
- US-A1- 2012 253 779
- CHARALAMPOS ROTSOS ET AL: "OFLOPS: An Open Framework for OpenFlow Switch Evaluation", 12 March 2012 (2012-03-12), PASSIVE AND ACTIVE MEASUREMENT, SPRINGER BERLIN HEIDELBERG, BERLIN, HEIDELBERG, PAGE(S) 85 - 95, XP019174162, ISBN: 978-3-642-28536-3 * the whole document *
- MACIEJ KUZNIAR ET AL: "OFTEN Testing OpenFlow Networks", SOFTWARE DEFINED NETWORKING (EWSDN), 2012 EUROPEAN WORKSHOP ON, IEEE, 25 October 2012 (2012-10-25), pages 54-60, XP032283470, DOI: 10.1109/EWSDN.2012.21 ISBN: 978-1-4673-4554-5

## Description

### BACKGROUND

In conventional networking, a switch receives a packet and determines a next hop to route the packet based on its routing table. Generally, all packets are routed in the same way and packets with the same destination are routed to the same next hop. Software defined networking (SDN) is a relatively new approach to computer networks that separates a control plane and a data plane. The control plane determines rules for routing packets and is implemented in software. The control plane may be provided in a central controller separate from the switch. The data plane forwards the packets and is located at the switch. The SDN architecture allows a network administrator to have programmable central control of network traffic without requiring physical access to the switches. Essentially, this allows use of less expensive, commodity switches and provides more control over network traffic.

Currently, a popular SDN protocol for an SDN network is OPENFLOW. OPENFLOW is an open standard maintained by the Open Networking Foundation. OPENFLOW enables a controller in the control plane to control routing in the data plane through a forwarding instruction set defined in the protocol. Document "OFLOPS: An Open Framework for OpenFlow Switch Evaluation, Charalampos Rotsos et al" describes a an open and generic software framework that permits the development of tests for OpenFlow-enabled switches, that measure the capabilities and bottlenecks between the forwarding engine of the switch and remote control applications. Document "OFTEN Testing OpenFlow Networks, Maciej Kuzniar et al" describes optimization methods for efficient and reliable OpenFlow switch black-box testing for integrated networks before deployment.

### BRIEF DESCRIPTION OF THE DRAWINGS

Embodiments are described in detail in the following description with reference to the following figures. The figures show examples of the embodiments and like reference numerals indicate similar elements in the accompanying figures.
Figure 1 illustrates a network switch simulation system.
Figure 2 illustrates a method for switch simulation.
Figures 3A-B illustrate another method for switch simulation.
Figure 4 illustrates a computer system that is operable to be used as a platform for the system shown in figure 1.

### DETAILED DESCRIPTION

For simplicity and illustrative purposes, the principles of the embodiments are described by referring mainly to examples thereof. In the following description, numerous specific details are set forth in order to provide a thorough understanding of the embodiments. It is apparent however, to one of ordinary skill in the art, that the embodiments may be practiced without limitation to these specific details. In some instances, well known methods and structures have not been described in detail so as not to unnecessarily obscure the description of the embodiments.

According to an embodiment, a network switch simulation system can test the scalability of a controller used in a network architecture comprised of a controller that can remotely program switches to control packet routing performed at the switch. For example, the simulation system may be used to test the performance of an SDN controller in a network employing the SDN architecture. Also, the simulation system may run simulations for an SDN controller employing the OPENFLOW protocol, referred to as an OPENFLOW controller. Embodiments and examples described below are generally described with respect to the simulation system used for an SDN controller which may be an OPENFLOW controller. However, the simulation system may be used to test the scalability of a controller in an SDN architecture that may use a protocol other than OPENFLOW. Furthermore, the simulation system may be used to test the scalability of a controller in architectures other than SDN that utilize a remote controller to promulgate routing rules to switches controlled by the remote controller. Some examples of the routing rules may be an action specifying a port for forwarding packets for a particular flow, prioritizing flows, de-prioritizing flows, blocking flows, etc.

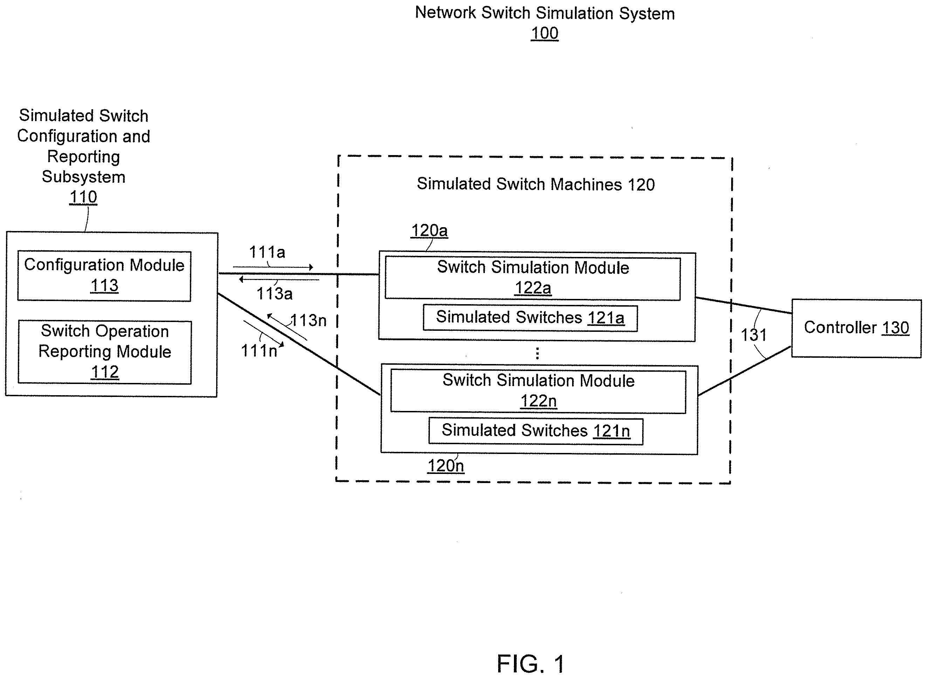

Figure 1 illustrates network switch simulation system 100. The system 100 includes simulated switch machines 120a-n having switch simulation modules 122a-n to simulate switches. For example, the switch simulation modules 122a-n may comprise code comprised of machined readable instructions executed by hardware to create simulated switches 121a-n. A simulated switch comprises code and/or hardware to emulate some switch operations described below. The switch operations for example include operations to test the performance of a remote controller 130. The operations may not include actual routing of data, such as forwarding packets received from a source to a destination, as would be performed by an actual switch but instead may include operations to solicit replies from the controller 130. The system 100 also includes a simulated switch configuration and reporting subsystem 110 including configuration module 111. The simulated switch configuration and reporting subsystem 110 may receive simulation information from a user or another system specifying constraints for a simulation. The configuration module 113 generates simulated switch configuration information, shown as 111a-n (collectively referred to as configuration information 111), based on the received information, which is sent to the simulated switch machines 120a-n to configure the simulated switch machines 120a-n to create the simulated switches 121a-n. The simulated switch configuration information 111 may include parameters for configuring and running the simulated switches. The parameters in the simulated switch configuration information 111 may specify the number of simulated switches to be simulated, number of packets to be sent, the length of time to send the packets, and other parameters.

One or more simulated switches, shown as 121a-n, are created on the simulated switch machines 120 according to the switch configuration information 111. For the simulated switches 121a-n, the simulated switch machines 120a-n for example execute the switch simulation modules 122a-n to simulate the operations of physical switches. The simulated switch machines 120a-n may include servers running the simulated switches 121a-n. Each of the simulated switch machines 120a-n may simulate multiple switches. Also, any number of switch machines may be used in the system 100 depending on the number of switches to be simulated.

The simulated switches 121a-n communicate with the controller 130, which may be referred to as a remote controller because it may be located on a computer separate from the simulated switch machines 120. The simulated switches 121a-n may communicate with the remote controller 130 over a network similar to an actual operating environment whereby a controller communicates with switches via a network. The controller 130 for example operates as the control plane for the simulated switches 121a-n in an SDN architecture. The controller 130 is capable of controlling and configuring switches. For example, the controller 130 may create and implement policies in the switches associated with routing, multicasting, security, access control, bandwidth management, traffic engineering, quality of service, processor and storage optimization, energy usage, etc. In one example, the controller 130 sends instructions that may include one or more actions to be performed by the switch for a particular flow or for one particular packet. A flow includes packets that have common attributes, such as common source and destination Internet Protocol (IP) addresses or Media Access Control (MAC) addresses, and other attributes which may be associated with any of layers 1-4 of the Open Systems Interconnection (OSI) model. An action may include an operation performed at the switch that forwards a packet to a port, floods the packet, or modifies the packet, such as decrementing a time to live field.

The controller 130 for example is a remote controller that runs on a computer system separate from the simulated switch machines 120. For example, it runs on its own server. The controller 130 is an actual controller rather than a simulated controller.

The simulated switches 121a-n may test the scalability of the controller 130. In one example, the controller 130 may be tested in the system 100 before being installed in actual operating environment. For example, the controller 130 may be designed to support thousands of switches simultaneously in a time-bounded manner, and the system 100 tests the capacity of the controller 130. Then, a system administrator may decide to deploy the controller 130 in the actual operating environment if the controller 130 operates as desired.

Testing controller 130 may include testing the number of concurrent connections the controller 130 can handle and testing the number of packets the controller 130 can handle in a time period, such as per second. For example, the switch simulation modules 122a-n create the simulated switches 121a-n. The number of simulated switches 121a-n created may be determined from the configuration information 111. The simulated switches 121a-n simultaneously initiate connections 131 to the controller 130. After the connections 131 are created, handshaking may be performed between the simulated switches 121a-n and the controller 130 per protocol requirements. The simulated switches 121a-n send messages to the controller 130 via the connections 131. The messages may include packets that are to be sent to the controller 130 to request the controller for instructions on how to handle packets received at the switch. The messages may be packet-in messages described in further detail below, which are packets specified by the OPENFLOW protocol. The simulated switches 121a-n expect reply messages from the controller 130. The reply messages may include instructions or actions for new flows received at the switch. The number of messages sent from the simulated switches 121a-n may be based on parameters in the configuration information 111a-n. Once the connections 131 are created, the simulated switches 121a-n can keep the connections 131 alive, for example, by responding to requests (e.g., echo requests) from the controller 130. The simulated switches 121a-n can also terminate any of the connections 130.

Examples of parameters that may be provided in the configuration information 111 for creating the simulated switches 121a-n and running a simulation may include IP address of a simulated switch machine where one or more simulated switches are to be created, name of file or script that is executed to simulate operation of a switch, range of IP and/or MAC addresses for simulated switches, IP address of the controller, number of packets a simulated switch has to send per second to the controller, total number of seconds to send the packets (e.g., send 200 packets per seconds for 1000 seconds), number of unique MAC ports in the simulated switch and vlan id. The simulated switch machine, which may comprise a virtual machine, hosting the simulated switch runs a program or script comprised of machine readable instructions that is identified in the configuration information to send packets to the controller 130. The number of packets and length of time to send packets is specified in the configuration information. Metrics measuring the performance of the controller 130 are collected during the simulation. The end of the time period for sending packets (e.g., 1000 seconds) is reached, and the metrics are sent to the simulated switch configuration and reporting subsystem 110.

For example, the metrics are determined and stored to evaluate the operation of the controller 130 during the simulation. The metrics may include timestamps for when a connection from a simulated switch was created and terminated. For each connection, the metrics may include number of packets sent, number of packets received, total time taken to send a specified number of packets, response times of the controller 130 to respond to messages in packets, whether the simulated switch was operable to establish a connection, whether the controller 130 improperly terminated a connection and other metrics. These metrics may be stored at the simulated switch machines 120a-n and sent to the simulated switch configuration and reporting subsystem 110. For example, metrics 113a-n are shown being sent from the simulated switch machines 120a-n to the simulated switch configuration and reporting subsystem 110.

A switch operation reporting module 112 may compile the metrics 113a-n and report the metrics. Reporting may include sending the metrics to another system or presenting the metrics via a graphical user interface. A system administrator may view the reported metrics to determine whether to deploy the controller 130. The reported metrics may include one or more of the metrics 113an. The reported metrics may also include number of simulated switches that were executed, information about the initial handshake for creating the connections 131, number of failed connections, total time taken for sending n number of messages from the simulated switches 121a-n to the controller 130 and/or from the controller 130 to the simulated switches 121a-n.

The simulated switch configuration and reporting subsystem 110 may run on a computer system, such as a server, separate from the simulated switch machines 120 and may communicate with the simulated switch machines 120 via a network, or the simulated switch configuration and reporting subsystem 110 may run on each of the simulated switch machines 120. For example, a guest operating system is executed on each of the simulated switch machines 120 to run the simulated switch configuration and reporting subsystem 110. In another example, the simulated switch machines 120 may create virtual machines to host the simulated switches 121a-n and the simulated switch configuration and reporting subsystem 110.

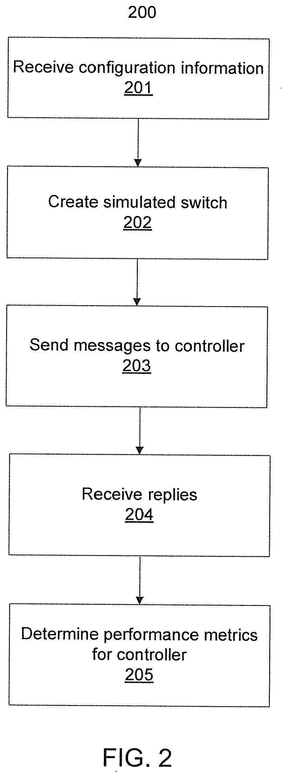

Methods 200 and 300 are described with respect to the system 100 shown in figure 1 by way of example. The methods may be performed by other systems. Figure 2 shows the method 200 for simulating a network switch. The method 200 may be performed to create and run any of the simulated switches 121a-n. At 201, configuration information, such as 111a, is received at the simulated switch machine 120a, which may be a server or other type of computer. At 202, the switch simulation module 122a creates the simulated switch 121 based on the configuration information 111a. The switch simulation module 122a may comprise code comprised of machine readable instructions that are executed to perform the operations of creating and sending messages to the controller 130 and responding to messages from the controller 130. The switch simulation module 122a may use parameters specified in the configuration information 111a to create and run the simulated switch 121a. The parameters may include switch configuration parameters such as IP address for the simulated switch 121a and the controller 130, number of ports, port MAC addresses, etc., and simulation parameters.

At 203, the simulated switch 121a sends messages, e.g., packet-in messages, to the controller 130 according to the simulation parameters in the configuration information 111a. The simulation parameters may include a maximum number of messages to be sent to the remote controller per a time interval and a total length of time to send the messages. For example, the simulation parameters may specify to send 200 packets per second to the controller 130 for 1000 seconds.

The simulation parameter may include a total number of unique flows to be sent to the controller 130. For example, packet-in messages sent from the simulated switched 121a may each include a unique source MAC to represent that the simulated switch 121a has received a new flow and is requesting the action to be taken for the flow from the controller 130. The controller 130 should reply to each packet-in message with an action. The total number of packet-in messages sent with unique MAC addresses may be determined from a simulation parameter.

At 204, the simulated switch 121a receives replies from the controller 130 responsive to the messages, and at 205, performance metrics are determined for the controller 130, such as a number of replies received from the remote controller in response to the messages and response times for responding to the messages. The performance metrics may include other metrics described herein. The performance metrics may be compiled from all the simulated switches 121a-n and sent to the switch operation reporting module 112 for analysis and reporting.

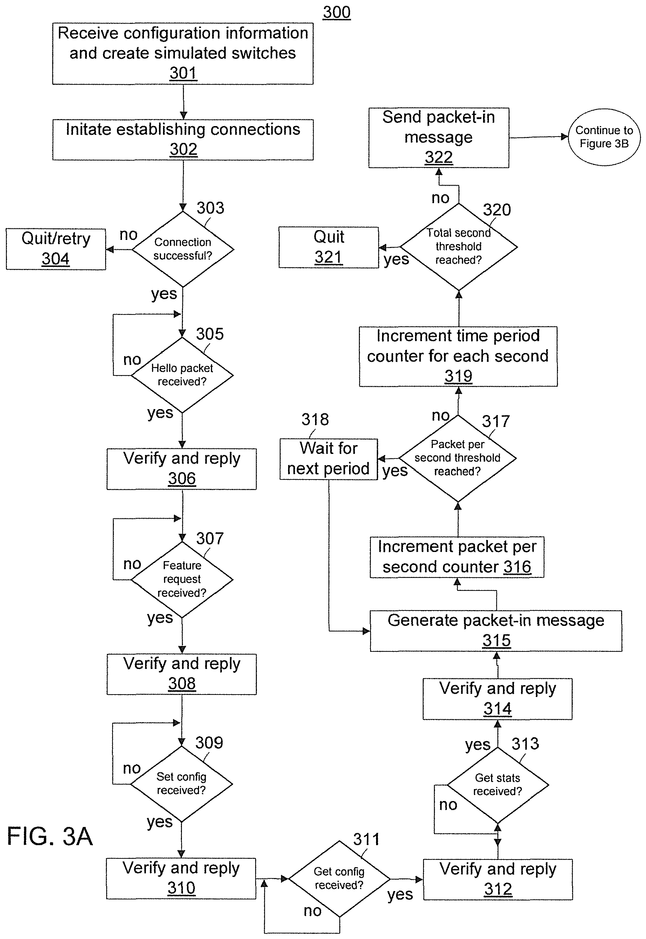

Figures 3A-B illustrate a method 300 for running a simulation with the simulated switches 121a-n according to the OPENFLOW protocol. Some of the messages described below are used in the OPENFLOW protocol.

At 301, the simulated switch machines 120a-n receive configuration information 111a-n and create the simulated switches 121a-n according to the configuration information 111a-n. The configuration information 111a-n may specify the number of switches to be created and other parameters. Some of the other parameters may include IP address of each switch, controller IP address, controller port, number of packet-in messages N to be sent per second and total number of seconds M to send the packet in messages, starting source MAC (to be sent in first packet-in message), starting destination MAC (to be sent in first packet-in message) and starting buffer ID (to be sent in first packet-in message). Other examples of parameters in the configuration 111 are described above.

At 302, the switches 121a-n initiate establishing the connections 131 with the controller 130. A connection may be created for message exchanges between a particular simulated switch and the controller 130 A connection may be assigned a unique ID so the controller 130 can keep track of the connections. One example of a connection is a transmission control protocol (TCP) session which may be initiated by the simulated switches 121a-n and is established through TCP handshaking. The connections 131 may include secure connections. For example, a Secure Sockets Layer (SSL) connection is initiated by the switches 121a-n on startup and is established through SSL handshaking, such as mutually authenticating by exchanging certificates signed by a site-specific private key to create a connection. In another example, the connections 131 may include Transport Layer Security (TLS) session which is established through TLS handshaking. A TLS session may be initiated by a simulated switch on startup.

At 303, the switches 121a-n determine if their respective connection was successively established. For example, the switches 121a-n receive reply messages from the controller 130 indicating an established connection. If the controller 130 does not respond to a message, for example within a predetermined time, the connection is not successful. If the connection is not successful, then at 304, the simulated switch may keep trying to establish a connection for a predetermined number of attempts and then quits. A failed connection is logged for the simulated switch. Terminated connections are also logged. For example, if a connection is successfully created but is later terminated for example due to timeouts, such as an echo request timeout, TLS session timeout, or other premature disconnection, the terminated connection is logged. The total number of failed and prematurely terminated connections are examples of some of the metrics determined for the controller 130.

Blocks 305-321 describe decisions performed by any of the simulated switches 121a-n and messages sent by any of the simulated switches 121a-n to the controller 130 that may be performed for protocol handshaking procedures. If a simulated switch is waiting for a message and it is not received within a predetermined time period, the connection may be terminated.

At 305, after establishing a connection, a simulated switch waits for a hello packet from the controller 130 and verifies and replies to the hello packet at 306, which indicates that they are still connected.

At 307, the simulated switch waits for a feature request packet. The controller 130 sends feature request packets to the simulated switches 121a-n to determine the features of a newly connected switch. At 308, the simulated switch verifies and responds to the feature request packet with a message that includes features of the simulated switch, such as number of ports, ports up ports down, system description, MAC address for each port, ports names, etc.

At 309, the simulated switch waits for a set configuration packet from the controller 130 that indicates one or parameters to be set in the simulated switch for communicating with the controller 130, such as maximum bytes for a packet. At 310, the simulated switch verifies and responds to the set configuration packet to acknowledge the parameters.

At 311, the simulated switch waits for a get configuration packet from the controller 130 that requests switch configuration parameters. At 312, the simulated switch verifies and responds to the get configuration packet by sending its configuration parameters to the controller 130.

At 313, the simulated switch may send a get statistics request to the controller 130 to determine if there are any preconfigured actions for flows. The controller 130 responds to the request with a reply that indicates whether there are any actions for particular flows that are to be performed by the switch. At 314, the simulated switch receives and verifies the reply.

After establishing the connections 131 and performing various handshaking procedures, such as described in one or more of blocks 305-321, the simulated switches 121a-n may send packet-in messages to the controller 130 to test performance of the controller 130. The packet-in messages are packets that include an OPENFLOW header. The controller 130 should respond to all the packet-in messages within a predetermined period of time. For example, for new flows, a packet-in message may be sent to the controller 130 from a switch to get a reply from the controller 130 indicating how the switch should handle packets for the flow. The controller 130 may respond with a packet-out message that identifies a port in the switch for the flow, and whenever packets for the flow are received at the switch, they are forwarded to the specified port. In another example, a response from the controller 130 to a packet-in message may include a flow-mod message which specifies an action to performed by the switch, such as modifying an entry in the switches flow table.

According to parameters specified in the configuration information 111a-n, the simulated switches 121a-n send a number of packet-in messages per second to the controller 130 and continue to send the packet-in messages for a specified number of seconds. Seconds are used as an example. A different time period may be specified by the configuration information 111a-n. Metrics are collected, such as the number of packet-in messages to which the controller 130 responds and the length of time to respond. Blocks 315 to 327 generally describe these features.

For example, at 315, a simulated switch generates a packet-in message to send to the controller 130. At 316, a counter at the simulated switch increments a per second counter. At 317, the simulated switch determines whether a packet per second threshold has been exceeded. For example, the configuration information for the simulated switch may specify that 200 packet-in messages are to be sent to the controller 130 per second. If 200 packet-in messages have already been sent for the current second, then at 318, the simulate switch waits till the next second to start sending packet-in messages and the counter is reset.

The configuration information for the simulated switch may specify that 200 packet-in messages per second are to be sent to the controller 130 for 1000 seconds. At 319 a time period counter is incremented each second and at 320 the time period counter is compared to the total second threshold (e.g., 1000 seconds). If 1000 seconds has passed since the first packet-in message was sent, then the simulated switch stops sending packets at 321. Otherwise, the packet-in message is sent at 322.

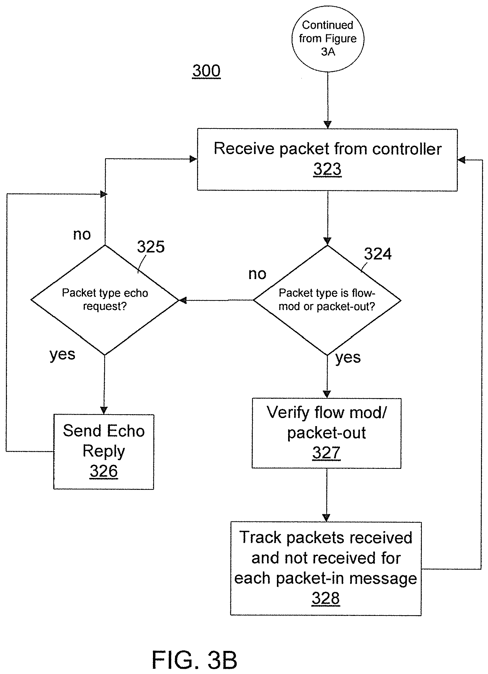

Referring to figure 3B, the simulated switch receives a packet from the controller 130 at 323. At 324, the simulated switch determines whether the received packet is a flow-mod packet or a packet-out packet. If yes, the simulated switch verifies the packet at 327 which may include determining which packet-in message the received packet corresponds with. For example, the simulated switch is sending many packet-in messages per second and thus is continuously receiving replies, such as flow-mod or packet-out messages, from the controller 130. The simulated switch identifies to which packet-in message each received flow-mod or packet-out message is a reply. The simulated switch may determine whether a reply was received from the controller 130 within a predetermined period of time for each packet-in message. At 328, the simulated switch tracks and stores the received replies and determines the response time to each packet-in message and also determines whether replies are received within the predetermined period of time. For example, the simulated switch can determine metrics such as the total in-packet messages that were sent, the total timely replies, and response times. The metrics collected for each simulated switch for the simulation may be sent to the switch operation reporting module 112 and subsequently reported to a user.

At 325, the simulated switch determines whether a packet received from the controller 130 is an echo request, which may be sent by the controller 130 to determine whether the simulated switch is still connected. The simulated switch sends an echo reply at 326 to the controller 130. Metrics may be collected regarding the number of echo requests and improperly terminated connections.

The blocks 315-328 may be performed by the switches 121a-n to collect the metrics regarding the performance of the controller 130. These metrics may be evaluated to determine how well the controller 130 is operating and to determine the performance limits of the controller 130. The simulations may be repeated for different parameters to identify the upper performance limits of the controller 130. Also, after the first packet-in messages are sent, the sending of in source code, object code, executable code or other formats.

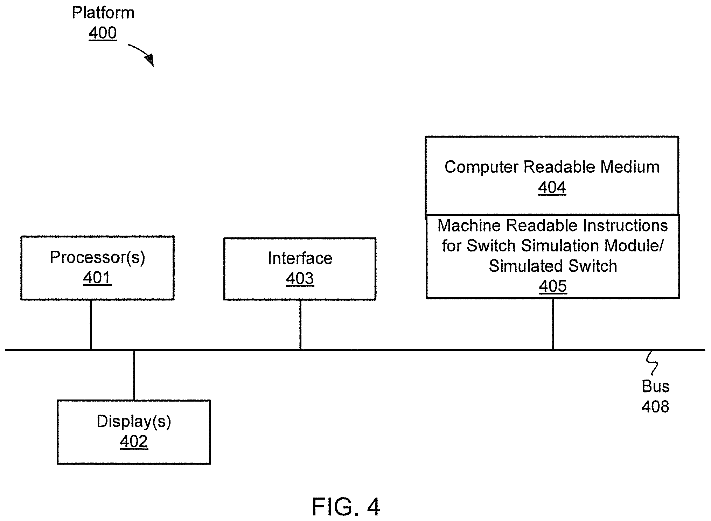

Referring to figure 4, there is shown a computer platform 400 that may be used for one or more of the simulated switch machines 120 to run the simulated switches 121a-n. It is understood that the illustration of the platform 400 is a generalized illustration and that the platform 400 may include additional components and that some of the components described may be removed and/or modified without departing from a scope of the platform 400.

The platform 400 includes processor(s) 401, such as a central processing unit, ASIC or other type of processing circuit; a display 402 and/or other input/output devices, an interface 403, such as a network interface to a Local Area Network (LAN), a wireless 802.11x LAN, a 3G or 4G mobile WAN or a WiMax WAN; and a computer-readable medium 404. Each of these components may be operatively coupled to a bus 408. A non-transitory computer readable medium (CRM), such as CRM 404 may be any suitable medium which stores instructions for execution by the processor(s) 401 for execution. For example, the CRM 404 may be non-volatile media, such as a magnetic disk or solid-state non-volatile memory or volatile media. The CRM 404 may include machine instructions 405 for the switch simulation module 122a and the simulated switch 121a.

While embodiments have been described with reference to the disclosure above, those skilled in the art are able to make various modifications to the described embodiments without departing from the scope of the embodiments as described in the following claims.

## Claims

1. A network switch simulation system (100) comprising:
a switch simulation module (122a-122n) executed by a processor to receive configuration information and create a simulated switch (121a-121n) on a simulated switch machine (120) based on switch configuration parameters in the configuration information; and
the simulated switch (121a-121n) is to send messages to a remote controller (130) located on a computer separate from the simulated switch machine (120) according to simulation parameters in the configuration information, and the switch simulation module (122a-122n) is to determine performance metrics for the remote controller (130) based on replies received from the remote controller (130) in response to the messages.

2. The system (100) of claim 1, wherein the simulation parameters include a maximum number of messages to be sent to the remote controller (130) per a time interval and a total length of time to send the messages, and the performance metrics comprise a number of replies received from the remote controller (130) in response to the messages and response times for responding to the messages.

3. The system (100) of claim 2, wherein to send the messages, the simulated switch (121a-121n) is to determine if a number of messages sent to the remote controller (130) for a current time interval is less than the maximum number of messages,
send another message for the current time interval if the determined number of messages sent to the remote controller (130) for the current time interval is less than the maximum number of messages, and
stop sending messages for the current time interval if the determined number of messages sent to the remote controller (130) for the current time interval is not less than the maximum number of messages.

4. The system (100) of claim 2, wherein to send the messages, the simulated switch (121a-121n) is to determine if a length of time the simulated switch has been sending messages is less than the total length of time to send the messages,
send another message to the remote controller (130) if the determined length of time the simulated switch (121a-121n) has been sending messages is less than the total length of time to send the messages, and
stop sending messages to the remote controller (130) if the determined length of time the simulated switch (121a-121n) has been sending messages is not less than the total length of time to send the messages.

5. The system (100) of claim 1, wherein the simulated switch (121a-121n) is to emulate switch operations of an actual network switch comprised of soliciting replies from the controller (130) without emulating routing performed by an actual network switch.

6. The system (100) of claim 1, wherein the messages sent to the remote controller include connection messages to establish a connection with the remote controller (130) over a network, and the simulated switch (121a-121n) is to establish the connection in response to replies received to the connection messages.

7. The system (100) of claim 6, wherein after establishing the connection, the messages sent to the remote controller (130) include handshake messages to request and receive controller configuration information from the remote controller (130) and provide switch configuration information to the remote controller (130) over the connection.

8. The system (100) of claim 7, wherein the simulated switch (121a-121n) is to receive a feature request message from the remote controller (130) via the connection and send a reply comprised of one of the handshake messages to the remote controller (130) via the connection, the reply including a number of ports in the simulated switch (121a-121n), ports that are up, ports that are down, and MAC address for each port.

9. The system (100) of claim 7, wherein the simulated switch (121a-121n) is to receive a set configuration message from the remote controller (130) via the connection indicating a parameter to be set in the simulated switch (121a-121n) for communicating with the remote controller (130), and send a reply comprised of one of the handshake messages to the remote controller (130) via the connection, the reply including verification the parameter has been set.

10. The system (100) of claim 7, wherein the simulated switch (121a-121n) is to receive a get configuration message from the remote controller (130) via the connection, and send a reply comprised of one of the handshake messages to the remote controller (130) via the connection, the reply including simulated switch configuration parameters.

11. The system (100) of claim 7, wherein the simulated switch (121a-121n) is to send one of the handshake messages to the remote controller (130) via the connection to request from the controller (130) any preconfigured actions for network flows stored in the remote controller (130).

12. The system (100) of claim 1, comprising:
a configuration module (113) to receive information from a user for performing a network switch simulation and to generate the configuration information from the received information; and
a switch operation reporting module (112) to generate a report of the performance metrics for a user or a computer system.

13. A method (200) of performing a network switch simulation comprising:
receiving (201) configuration information;
creating (202) a simulated switch on a simulated switch machine based on switch configuration parameters in the configuration information;
sending (203) messages to a remote controller located on a computer separate from the simulated switch machine according to simulation parameters in the configuration information;
receiving (204) replies from the remote controller responsive to the messages; and
determining (205) performance metrics for the remote controller based on the message and the replies.

14. The method (200) of claim 13, wherein the simulation parameters include a maximum number of messages to be sent to the remote controller per a time interval and a total length of time to send the messages, and the performance metrics comprise a number of replies received from the remote controller in response to the messages and response times for responding to the messages.

15. A non-transitory computer readable medium (404) including machine readable instructions (405) executed by at least one processor (401) to:
receive configuration information to simulate a network switch in a software defined networking architecture;
create the simulated switch on a simulated switch machine separate from the remote controller's computer based on switch configuration parameters in the configuration information, wherein a control plane determining routing rules is provided in the remote controller;
send packet-in messages to the remote controller according to simulation parameters in the configuration information, wherein each of the packet-in messages include information for a new network flow;
receive replies from the remote controller responsive to the packet-in messages, wherein the replies include flow-mod messages or packet-out messages specifying an action for routing each new network flow; and
determine performance metrics for the remote controller based on the sent packet-in messages and the replies.

## Patentansprüche

1. Netzwerk-Switch-Simulationssystem (100), umfassend:
ein Switch-Simulationsmodul (122a-122n), das von einem Prozessor zum Empfangen von Konfigurationsinformationen und zum Erzeugen eines simulierten Switches (121a-121n) auf einem simulierten Schaltgerät (120) basierend auf Switch-Konfigurationsparametern in den Konfigurationsinformationen ausgeführt wird; und
wobei der simulierte Switch (121a-121n) Meldungen an eine Fernsteuerung (130), die sich auf einem von dem simulierten Schaltgerät (120) getrennten Computer befindet, gemäß Simulationsparametern in den Konfigurationsinformationen senden soll, und wobei das Switch-Simulationsmodul (122a-122n) Leistungskennzahlen für die Fernsteuerung (130) basierend auf Antworten, die von der Fernsteuerung (130) als Reaktion auf die Meldungen erhaltenen werden, bestimmen soll.

2. System (100) nach Anspruch 1, wobei die Simulationsparameter eine maximale Anzahl an Meldungen beinhalten, die an die Fernsteuerung (130) innerhalb eines Zeitintervalls und eines Gesamtzeitraums zum Senden der Meldungen zu senden sind, und wobei die Leistungskennzahlen eine Anzahl von Antworten umfassen, die von der Fernsteuerung (130) als Reaktion auf die Meldungen und Antwortzeiten zum Beantworten der Meldungen empfangen werden.

3. System (100) nach Anspruch 2, wobei der simulierte Switch (121a-121n) zum Senden der Meldungen ermitteln soll, ob eine Anzahl von Meldungen, die in einem aktuellen Zeitintervall an die Fernsteuerung (130) gesendet werden, geringer ist als die maximale Anzahl an Meldungen,
wobei eine weitere Meldung in dem aktuellen Zeitintervall gesendet wird, wenn die ermittelte Anzahl an Meldungen, die an die Fernsteuerung (130) in dem aktuellen Zeitintervall gesendet werden, geringer ist als die maximale Anzahl an Meldungen, und
wobei das Senden von Meldungen in dem aktuellen Zeitintervall beendet wird, wenn die ermittelte Anzahl an Meldungen, die an die Fernsteuerung (130) in dem aktuellen Zeitintervall gesendet werden, nicht geringer ist als die maximale Anzahl an Meldungen.

4. System (100) nach Anspruch 2, wobei der simulierte Switch (121a-121n) zum Senden der Meldungen ermitteln soll, ob ein Zeitraum, über den der simulierte Switch Meldungen gesendet hat, geringer ist als der gesamte Zeitraum zum Senden der Meldungen,
wobei eine weitere Meldung an die Fernsteuerung (130) gesendet wird, wenn der ermittelte Zeitraum, über den der simulierte Switch (121a-121n) Meldungen sendet, geringer ist als der gesamte Zeitraum zum Senden der Meldungen, und
wobei das Senden von Meldungen an die Fernsteuerung (130) beendet wird, wenn der ermittelte Zeitraum, über den der simulierte Switch (121a-121n) Meldungen sendet, nicht geringer ist als der gesamte Zeitraum zum Senden der Meldungen.

5. System (100) nach Anspruch 1, wobei der simulierte Switch (121a-121n) Schaltvorgänge eines tatsächlichen Netzwerk-Switches emulieren soll, bestehend aus Erbitten von Antworten von der Steuerung (130), ohne ein von einem tatsächlichen Netzwerk-Switch ausgeführtes Routing zu emulieren.

6. System (100) nach Anspruch 1, wobei die an die Fernsteuerung gesendeten Meldungen Verbindungsmeldungen umfassen, um eine Verbindung mit der Fernsteuerung (130) über ein Netzwerk aufzubauen, und wobei der simulierte Switch (121a-121n) die Verbindung als Reaktion auf Antworten, die auf die Verbindungsmeldungen erhalten werden, herstellen soll.

7. System (100) nach Anspruch 6, wobei die an die Fernsteuerung (130) gesendeten Meldungen nach Aufbauen der Verbindung Handshake-Meldungen beinhalten, um Steuerungs-Konfigurationsinformationen von der Fernsteuerung (130) anzufordern und zu empfangen und um Switch-Konfigurationsinformationen für die Fernsteuerung (130) über die Verbindung bereitzustellen.

8. System (100) nach Anspruch 7, wobei der simulierte Switch (121a-121n) eine Feature-Request-Meldung von der Fernsteuerung (130) über die Verbindung empfangen soll und eine Antwort, die eine der Handshake-Meldungen umfasst, an die Fernsteuerung (130) über die Verbindung senden soll, wobei die Antwort eine Anzahl von Ports im simulierten Switch (121a-121n), Ports, die im Up-Zustand sind, Ports, die im Down-Zustand sind, und die MAC-Adresse für jeden Port beinhaltet.

9. System (100) nach Anspruch 7, wobei der simulierte Switch (121a-121n) eine festgelegte Konfigurationsmeldung von der Fernsteuerung (130) über die Verbindung empfangen soll, die einen in dem simulierten Switch (121a-121n) festzulegenden Parameter zum Kommunizieren mit der Fernsteuerung (130) anzeigt, und eine Antwort, bestehend aus einer der Handshake-Meldungen, über die Verbindung an die Fernsteuerung (130) senden soll, wobei die Antwort einen Nachweis, dass der Parameter festgelegt wurde, beinhaltet.

10. System (100) nach Anspruch 7, wobei der simulierte Switch (121a-121n) eine Erhalten-Konfigurationsmeldung von der Fernsteuerung (130) über die Verbindung empfangen soll und eine Antwort, bestehend aus einer der Handshake-Meldungen, an die Fernsteuerung (130) über die Verbindung senden soll, wobei die Antwort simulierte Switchkonfigurationsparameter beinhaltet.

11. System (100) nach Anspruch 7, wobei der simulierte Switch (121a-121n) eine der Handshake-Meldungen an die Fernsteuerung (130) über die Verbindung senden soll, um von der Steuerung (130) alle vorkonfigurierten Aktionen für Netzwerkströme, die in der Fernsteuerung (130) gespeichert sind, anzufordern.

12. System (100) nach Anspruch 1, umfassend:
ein Konfigurationsmodul (113), um Informationen von einem Benutzer zum Durchführen einer Netzwerk-Switch-Simulation zu empfangen und um die Konfigurationsinformationen aus den erhaltenen Informationen zu erzeugen; und
ein Switch-Betrieb-Berichtsmodul (112), um einen Bericht über die Leistungskennzahlen für einen Benutzer oder ein Computersystem zu erstellen.

13. Verfahren (200) zum Durchführen einer Netzwerk-Switch-Simulation, umfassend:
Empfangen (201) von Konfigurationsinformationen;
Erzeugen (202) eines simulierten Switches auf einem simulierten Schaltgerät basierend auf Switch-Konfigurationsparametern in den Konfigurationsinformationen;
Senden (203) von Meldungen an eine Fernsteuerung, die sich auf einem von dem simulierten Schaltgerät getrennten Computer befindet, gemäß Simulationsparametern in den Konfigurationsinformationen;
Empfangen (204) von Antworten von der Fernsteuerung als Reaktion auf die Meldungen; und
Ermitteln (205) von Leistungskennzahlen für die Fernsteuerung basierend auf der Meldung und den Antworten.

14. Verfahren (200) nach Anspruch 13, wobei die Simulationsparameter eine maximale Anzahl an Meldungen enthalten, die an die Fernsteuerung innerhalb eines Zeitintervalls und eines Gesamtzeitraums zum Senden der Meldungen zu senden sind, und wobei die Leistungskennzahlen eine Anzahl von Antworten umfassen, die von der Fernsteuerung als Reaktion auf die Meldungen und Antwortzeiten für die Beantwortung der Meldungen empfangen werden.

15. Nicht-transitorisches, computerlesbares Medium (404), das maschinenlesbare Anweisungen (405), die von mindestens einem Prozessor (401) ausgeführt werden, beinhaltet, zum:
Empfangen von Konfigurationsinformationen zur Simulation eines Netzwerk-Switches in einer softwaredefinierten Netzwerkarchitektur;
Erzeugen des simulierten Switches auf einem simulierten Schaltgerät, das von dem Computer der Fernsteuerung getrennt ist, basierend auf Switch-Konfigurationsparametern in den Konfigurationsinformationen, wobei in der Fernsteuerung eine Steuerebene, die Routing-Regeln bestimmt, bereitgestellt ist;
Senden von Packet-In-Meldungen an die Fernsteuerung gemäß Simulationsparametern in den Konfigurationsinformationen, wobei jede der Packet-In-Meldungen Informationen für einen neuen Netzwerkstrom beinhaltet;
Empfangen von Antworten von der Fernsteuerung als Reaktion auf die Packet-In-Meldungen, wobei die Antworten FlowMod-Meldungen oder Packet-Out-Meldungen beinhalten, die eine Aktion für das Routing jedes neuen Netzwerkstroms festlegen; und
Ermitteln der Leistungskennwerte für die Fernsteuerung basierend auf den gesendeten Packet-In-Meldungen und den Antworten.

## Revendications

1. Système de simulation de commutateur réseau (100) comprenant:
un module de simulation de commutation (122a-122n) exécuté par un processeur en vue de recevoir des informations de configuration et créer un commutateur simulé (121a-121n) sur une machine à commutation simulée (120) sur la base de paramètres de configuration de commutateur; et
le commutateur simulé (121a-121n) devant envoyer des messages à une unité de commande à distance (130) située sur un ordinateur séparé de la machine à commutation simulée (120) en fonction de paramètres de simulation dans les informations de configuration, et le module de simulation de commutation (122a-122n) devant déterminer des mesures de performance pour l'unité de commande à distance (130) sur la base des réponses reçues de l'unité de commande à distance (130) en réponse aux messages.

2. Système (100) selon la revendication 1, dans lequel les paramètres de simulation comportent un nombre maximal de messages à envoyer à l'unité de commande à distance (130) par intervalle de temps et une durée totale d'envoi des messages, et les mesures de performance comprennent un nombre de réponses reçues de l'unité de commande à distance (130) en réponse aux messages et aux temps de réponse pour répondre aux messages.

3. Système (100) selon la revendication 2, dans lequel en vue d'envoyer les messages, le commutateur simulé (121a-121n) doit
déterminer si un nombre de messages envoyés à l'unité de commande à distance (130) pour un intervalle de temps en cours est inférieur au nombre maximal de messages,
envoyer un autre message pour l'intervalle de temps en cours si le nombre déterminé de messages envoyés à l'unité de commande à distance (130) pour l'intervalle de temps en cours est inférieur au nombre maximal de messages, et
arrêter d'envoyer des messages pour l'intervalle de temps en cours si le nombre déterminé de messages envoyés à l'unité de commande à distance (130) pour l'intervalle de temps en cours n'est pas inférieur au nombre maximal de messages.

4. Système (100) selon la revendication 2, dans lequel en vue d'envoyer les messages, le commutateur simulé (121a-121n) doit
déterminer si une durée pendant laquelle le commutateur simulé envoie des messages est inférieure à la durée totale d'envoi des messages,
envoyer un autre message à l'unité de commande à distance (130) si la durée déterminée pendant laquelle le commutateur simulé (121a-121n) envoie des messages est inférieure à la durée totale d'envoi des messages, et
arrêter d'envoyer des messages à l'unité de commande à distance (130) si la durée déterminée pendant laquelle le commutateur simulé (121a-121n) envoie des messages n'est pas inférieure à la durée totale d'envoi des messages.

5. Système (100) selon la revendication 1, dans lequel le commutateur simulé (121a-121n) doit émuler les opérations de commutation d'un commutateur réseau réel, consistant à solliciter des réponses de l'unité de commande (130) sans émuler le routage effectué par un commutateur réseau réel.

6. Système (100) selon la revendication 1, dans lequel les messages envoyés à l'unité de commande à distance comportent des messages de connexion en vue d'établir une connexion avec l'unité de commande à distance (130) via un réseau, et le commutateur simulé (121a-121n) doit établir la connexion en réponse aux réponses reçues aux messages de connexion.

7. Système (100) selon la revendication 6, dans lequel, après que la connexion a été établie, les messages envoyés à l'unité de commande à distance (130) comportent des messages d'établissement de liaison en vue de demander et recevoir des informations de configuration de commande de l'unité de commande (130) et fournir des informations de configuration de commutateur à l'unité de commande à distance (130) via la connexion.

8. Système (100) selon la revendication 7, dans lequel le commutateur simulé (121a-121n) doit recevoir via la connexion un message de demande de fonctionnalité de l'unité de commande à distance (130) et envoyer une réponse consistant en l'un des messages d'établissement de liaison à l'unité de commande à distance (130) via la connexion, la réponse comportant un certain nombre de ports dans le commutateur simulé (121a-121n), certains ports étant ouverts, d'autres ports étant fermés, et l'adresse MAC de chaque port.

9. Système (100) selon la revendication 7, dans lequel le commutateur simulé (121a-121n) doit recevoir via la connexion un message de configuration fixe de l'unité de commande à distance (130) indiquant un paramètre à définir dans le commutateur simulé (121a -121n) pour communiquer avec l'unité de commande à distance (130), et envoyer une réponse consistant en l'un des messages d'établissement de liaison à l'unité de commande à distance (130) via la connexion, la réponse comportant la vérification que le paramètre a bien été défini.

10. Système (100) selon la revendication 7, dans lequel le commutateur simulé (121a-121n) doit recevoir un message de configuration à obtenir de l'unité de commande à distance (130) via la connexion et envoyer une réponse consistant en l'un des messages d'établissement de liaison à l'unité de commande à distance (130) via la connexion, la réponse comportant des paramètres de configuration du commutateur simulé.

11. Système (100) selon la revendication 7, dans lequel le commutateur simulé (121a-121n) doit envoyer l'un des messages d'établissement de liaison à l'unité de commande à distance (130) via la connexion en vue de demander à l'unité de commande à distance (130) l'une quelconque des actions préconfigurées pour les flux de réseau stockés dans l'unité de commande à distance (130).

12. Système (100) selon la revendication 1, comprenant:
un module de configuration (113) en vue de recevoir des informations d'un utilisateur pour effectuer une simulation de commutation de réseau et en vue de générer les informations de configuration à partir des informations reçues; et
un module de rapport de fonctionnement de commutateur (112) en vue de générer un rapport sur les mesures de performance pour un utilisateur ou un système informatique.

13. Procédé (200) d'exécution d'une simulation de commutation réseau consistant à:
recevoir (201) des informations de configuration;
créer (202) un commutateur simulé sur une machine à commutation simulée sur la base des paramètres de configuration de commutateur dans les informations de configuration;
envoyer (203) des messages à une unité de commande à distance située sur un ordinateur séparé de la machine à commutation simulée en fonction de paramètres de simulation dans les informations de configuration;
recevoir (204) des réponses de l'unité de commande à distance en réponse aux messages; et
déterminer (205) des mesures de performance pour l'unité de commande à distance sur la base du message et des réponses.

14. Procédé (200) selon la revendication 13, dans lequel les paramètres de simulation comportent un nombre maximal de messages à envoyer à l'unité de commande à distance par intervalle de temps et une durée totale d'envoi des messages, et les mesures de performance comprennent un nombre de réponses reçues de l'unité de commande à distance en réponse aux messages et aux temps de réponse pour répondre aux messages.

15. Support (404) non-transitoire et lisible par ordinateur comportant des instructions lisibles par machine (405) exécutées par au moins un processeur (401) en vue:
de recevoir des informations de configuration en vue de simuler un commutateur réseau dans une architecture de réseau définie par logiciel;
de créer le commutateur simulé sur une machine à commutation simulée séparée de l'ordinateur de l'unité de commande à distance sur la base des paramètres de configuration de commutateur dans les informations de configuration, un plan de commande déterminant des règles de routage étant fourni dans l'unité de commande à distance;
d'envoyer des messages de transmission par paquets à l'unité de commande à distance en fonction des paramètres de simulation dans les informations de configuration, chacun des messages de transmission par paquets comportant des informations pour un nouveau flux de réseau;
de recevoir des réponses de l'unité de commande à distance en réponse aux messages de transmission par paquets, les réponses comportant des messages de modulation de flux ou des messages de libération de paquets spécifiant une action pour acheminer chaque nouveau flux de réseau; et
de déterminer les mesures de performance pour l'unité de commande à distance sur la base des messages de transmission par paquets envoyés et des réponses.
